# EUROPÄISCHE PATENTSCHRIFT

(11) **EP 1 278 303 B1**
(45) Veröffentlichungstag und Bekanntmachung des Hinweises auf die Patenterteilung: **28.01.2009**
(21) Anmeldenummer: 02010413.9
(22) Anmeldetag: 08.05.2002
(51) Int. Cl.: H03H 11/24

(54) **Integrierte HF-Schaltung zur Amplitudenbeeinflussung von Signalen**
Integrated HF-circuit for influencing signal amplitudes
Circuit intégré HF pour influencer l'amplitude des signaux

(30) Priorität: 26.06.2001 DE 10130764
(43) Veröffentlichungstag der Anmeldung: 22.01.2003
(73) Patentinhaber: EADS Deutschland GmbH, 81663 München (DE)
(72) Erfinder: Ludwig, Michael, 89155 Erbach (DE); Reber, Rolf, 89077 Ulm (DE)
(74) Vertreter: Meel, Thomas

(56) Entgegenhaltungen:
- US-A- 4 996 504
- US-A- 5 049 841

## Beschreibung

Die Erfindung betrifft eine integrierte HF-Schaltung mit Dämpfungsgliedern zur Amplitudenstellung eines der HF-Schaltung zugeführten Sollsignals in ein in der HF-Schaltung erzeugten Istsignal.

In den üblicherweise verwendeten integrierten Hochfrequenzschaltungen zur Amplitudenbeeinflussung von Signalen, welche insbesondere Schaltelemente auf Basis von MESFET (Metal Semiconductor Feldeffekttransistor) oder HEMT (High Electron Mobility Transistor) aufweisen, kommt es zu unerwünschten Phasenveränderungen der Signale. Bekanntermaßen werden diese unerwünschten Phasenveränderungen mittels aufwendiger Schaltungen und Algorithmen kompensiert. Eine derartige integrierte HF-Schaltung, bei der die Amplitudenbeeinflussung der Signale mittels unkompensierter Dämpfungsgliedern erfolgt, ist bei Brian Bedard; "Fast GaAs MMIC attenuator has 5-b resolution"; Microwaves & RF; Oktober 1991, Seiten 71-76 beschrieben. In EP 0 360 916 A1 wird ein weiteres phasenunkompensiertes Dämpfungsglied beschrieben.

Außerdem benötigen herkömmliche HF-Schaltungen zum Einstellen der jeweiligen Betriebszustände negative Steuerspannungen. Die digitalen Logikschaltungen mit denen die HF-Schaltungen angesteuert werden, arbeiten allerdings mit positiven Spannungen. Dies ist insofern nachteilig, da die herkömmlichen HF-Schaltungen zwei Versorgungsspannungen benötigen. Aus diesem Grund werden zusätzliche Interface (z.B. Pegelwandler) zwischen der HF-Schaltung und der digitalen Logikschaltung benötigt. Dadurch ergeben sich weitere Nachteile hinsichtlich des Platzbedarfs auf einem Microchip in den die HF-Schaltung integriert ist. Weitere Nachteile sind die größere Schaltzeit, der hohe Stromverbrauch und die hohen Gestehungskosten.

In US 5,796,286 wird ein Dämpfungsglied mit zwei Dämpfungszuständen beschrieben. Das Umschalten zwischen den Dämpfungszuständen erfolgt mittels Feldeffekttransistoren (FET), die in einen leitenden und sperrenden Zustand geschaltet werden können. Die Ansteuerung der FET erfolgt mittels einer Konstantstromquelle, die von einer positiven Versorgungsspannung gespeist wird. Hieraus entsteht der Nachteil eines hohen Stromverbrauchs des Dämpfungsglieds. Weiterer Nachteile sind die hohen Gestehungskosten und der hohe Raumbedarf des Dämpfungsglieds.

Aufgabe der Erfindung ist es, eine integrierte HF-Schaltung zur Amplitudenbeeinflussung von Signalen anzugeben, welche phasenkompensiert ist und mit welcher der Platzbedarf, die Schaltzeit und die Gestehungskosten einer derartigen HF-Schaltung auf einem Microchip reduziert werden können.

Diese Aufgabe wird mit den Merkmalen der integrierten HF-Schaltung des Patentanspruchs 1 gelöst. Vorteilhafte Ausführungen der HF-Schaltung sind Gegenstand von weiteren Ansprüchen.

Erfindungsgemäß weisen die Dämpfungsglieder zur Phasenkompensation Induktivitäten und/oder Kapazitäten auf. Außerdem sind die Feldeffekttransistoren leistungslos ansteuerbar. Der Vorteil ist, dass im Gegensatz zum Stand der Technik kein zusätzliches Interface zwischen der digitalen Logikschaltung und der HF-Schaltung benötigt wird. Dadurch wird die Schaltzeit der erfindungsgemäßen HF-Schaltung wesentlich verkürzt. Des weiteren benötigt die erfindungsgemäße HF-Schaltung auf einem Microchip weniger Raum, wodurch die Gestehungskosten reduziert werden. Ein weiterer Vorteil ist, dass die erfindungsgemäße integrierte HF-Schaltung nur eine Versorgungsspannung benötigt. Ein weiterer Vorteil ist, dass mit der erfindungsgemäßen leistungslosen Ansteuerung der Feldeffekttransistoren in den Dämpfungsgliedern kein Strom verbraucht wird.

Mit der erfindungsgemäßen integrierten HF-Schaltung erfolgt die Amplitudenstellung in festen Schritten durch vorteilhaft hintereinander, in Reihe geschaltete Dämpfungsglieder. Die Dämpfungsglieder sind vorteilhaft jeweils in einen Zustand mit wenig Verlust (Dämpfung) und mit definiertem Verlust schaltbar. Der Vorteil hierbei ist, dass dadurch eine definierte Einstellung der Signalleistung oder der Signalamplitude in mehreren Schritten erreichen werden kann. Sind z.B. alle Dämpfungsglieder in einen Zustand mit minimalen Verlust geschaltet, so wird die Signalamplitude des Istsignals maximal.

In den einzelnen Dämpfungsgliedern werden die Induktivitäten und/oder Kapazitäten vorteilhaft derart miteinander verschaltet, dass eine unerwünschte Phasenänderung des Sollsignals, also des zu beeinflussenden Signals, in dem Dämpfungsglied kompensiert wird. Ohne zusätzliche Maßnahmen ist die Durchgangsphase eines einzelnen Dämpfungsglieds abhängig vom Schaltungszustand (wenig Verlust oder definierter Verlust). Durch die Umschaltung in dem Dämpfungsglied erfährt das Sollsignal (das zu beeinflussende Signal) nicht nur eine Amplitudenänderung, sondern auch eine unerwünschte Phasenänderung. Die erfindungsgemäß in der HF-Schaltung vorhandenen Kapazitäten und/oder Induktivitäten bewirken eine zusätzliche Phasenänderungen, die der unerwünschten Phasenänderungen entgegengerichtet ist und diese somit kompensiert.

Die Dämpfungsglieder weisen bevorzugt eine Dämpfung von 0,5 dB, 1 dB, 2 dB, 4 dB, 8 dB, 16 dB auf. Es ist aber auch beliebig binäre Teilungen möglich, z.B. 0,75 dB, 1,5 dB, 3 dB, 6 dB usw. oder 0,45 dB, 0,9 dB, 1,8 dB, 3,6 dB, 7,2 dB usw. Außerdem können auch nichtbinäre Teilungen verwendet werden, z.B. 0,71 dB, 1,27 dB, 2,26 dB, 4 dB, 7,2 dB usw.

Als Schaltelemente dienen insbesondere Feldeffekttransistoren, die über eine Eingangsspannung (auch als Gate-Spannung bezeichnet) in einen leitenden und einen sperrenden Zustand gebracht werden. Es können aber auch Bipolartransistoren eingesetzt werden, die bei Ansteuerung mit einem kleinen Basisstrom in einen leitenden Zustand gebracht werden können. Erfindungsgemäß besitzen diese Schaltelemente eine positive Versorgungsspannung. Dies wird insbesondere dadurch realisiert, dass die Dämpfungsglieder mit einer positiven Spannung versorgt werden. Vorteilhaft sind die Schaltelemente mittels positiver Digitalpegel, insbesondere TTL- oder CMOS-Pegel ansteuerbar.

Die Reihenfolge der Verschaltung der einzelnen Dämpfungsgliedern hängt von den Systemüberlegungen ab und kann somit unterschiedlich ausfallen. So ist es in einer vorteilhaften Ausführung der Erfindung möglich, dass zwischen Dämpfungsgliedern zusätzliche Verstärkerstufen geschaltet werden. Die Verstärkerstufen bewirken eine Entkopplung der einzelnen Dämpfungsgliedern und ermöglichen so eine ungestörte Addition der einzelnen Dämpfungszustände in den jeweiligen Dämpfungsgliedern. Außerdem wirken sich die Verstärkerstufen vorteilhaft auf die Rauschzahl und die Aussteuerbarkeit (Kompressionpunkt) der integrierten HF-Schaltung aus.

Um eine HF-Schaltung mit einer niedrigen Rauschzahl zu erhalten, können in einer beispielhaften HF-Schaltung die Dämpfungsglieder mit niedrigen Dämpfungswerten, z.B. 0,5 dB, 1 dB, 2 dB, zwischen einem ersten und einem zweiten Verstärker und Dämpfungsglieder mit höheren Dämpfungswerten hinter den zweiten Verstärker geschaltet werden.

Die erfindungsgemäße integrierte HF-Schaltung kann bevorzugt in allen Anwendungen in denen Signale in ihrer Amplitude beeinflußt werden müssen, z.B. T/R-Module (Transmit/Receive-Module), regelbare Empfänger, Modulatoren für die Nachrichtenübertragung, eingesetzt werden. Insbesondere ist die erfindungsgemäße HF-Schaltung in integrierter Technologie, z.B. GaAs HEMT-Technologie realisierbar.

Weitere Vorteile der erfindungsgemäßen integrierten HF-Schaltung sind die Vereinfachung des Kalibrationsaufwandes im Sende- und Empfangsfall in Active-Phased-Array T/R-Modulen. Außerdem wird der Ansteuerungsaufwand innerhalb des Moduls vereinfacht.

Die Erfindung wird im folgenden anhand von Zeichnungen näher erläutert. Es zeigen:
- Fig. 1 :: eine Ausführungsform einer erfindungsgemäßen HF-Schaltung für ein Dämpfungsglied mit einem Dämpfungswert von 0,5 dB,
- Fig. 2 :: eine Ausführungsform einer erfindungsgemäßen HF-Schaltung für ein Dämpfungsglied mit einem Dämpfungswert von 1 dB, 2 dB oder 4 dB,
- Fig. 3 :: eine Ausführungsform einer erfindungsgemäßen HF-Schaltung für ein Dämpfungsglied mit einem Dämpfungswert von 8 dB,
- Fig. 4 :: eine Ausführungsform einer erfindungsgemäßen HF-Schaltung für ein Dämpfungsglied mit einem Dämpfungswert von 16 dB,
- Fig. 5 :: eine beispielhafte Kombination von den erfindungsgemäßen Dämpfungsgliedern mit verschiedenen Dämpfungswerten.

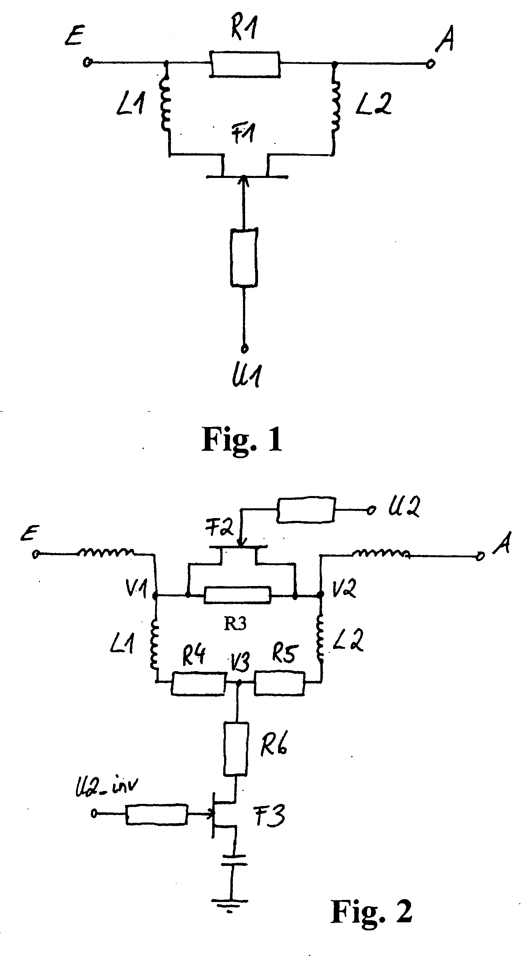

Fig. 1 zeigt eine Ausführungsform einer erfindungsgemäßen HF-Schaltung für ein Dämpfungsglied mit einem Dämpfungswert von 0,5 dB. Das Sollsignal E wird der HF-Schaltung an dem Verbindungspunkt des Widerstands R1 und der Induktivität L1 zugeführt. Das Istsignal A wird der HF-Schaltung an dem Verbindungspunkt des Widerstands R2 und der Induktivität L2 entnommen. Die beiden Induktivitäten L1, L2 sind jeweils mit einem Ausgang des Transistors F1 verbunden. Über den Eingang des Transistors wird die HF-Schaltung mit der Spannung U1 versorgt.

Im Zustand minimaler Dämpfung ist der Transistor F1 leitend, d.h. am Eingang liegt eine positive Spannung an. Liegt am Eingang des Transistors F1 allerdings die Spannung U1 = 0V an, dann wird das Sollsignal S gedämpft. Die Dämpfung erfolgt dabei mittels des Widerstandes R1. Die Induktivitäten L1 und L2 dienen der Phasenkompensation. Je nach Induktionswert können die Induktivitäten als Spiralspulen oder Leitungsstücke, z.B. Mikrostreifenleitungen realisiert werden.

Fig. 2 zeigt eine Ausführungsform einer erfindungsgemäßen HF-Schaltung für ein Dämpfungsglied mit einem Dämpfungswert von 1 dB, 2 dB oder 4 dB. Je nach Dämpfungswert sind die Werte der Induktivitäten und Kapazitäten anzupassen.

Das Sollsignal E wird der HF-Schaltung über eine Induktivität - zur Verbesserung der Anpassung - dem Verbindungspunkt V1 von Widerstand R3, der Induktivität L1 und einem Ausgang des Transistors F2 zugeführt. Der andere Ausgang des Transistors F2 ist mit dem Verbindungspunkt V2 des Widerstands R3 und der Induktivität L2 verbunden. Das Istsignal A wird der HF-Schaltung über eine mit dem Verbindungspunkt V2 verbundene Induktivität, welche der Anpassungverbesserung dient, entnommen. Am Eingang des Transistors F2 liegt über einen Widerstand die Spannung U2 an.

Die beiden Induktivitäten L1 und L2 sind über die Widerstände R4 und R5 im Verbindungspunkt V3 miteinander verbunden. Ein Ausgang des Transistors F3 ist über den Widerstand R6 mit dem Verbindungspunkt V3 verbunden. Der andere Ausgang des Transistors F4 ist über eine Kapazität mit Masse verbunden. Am Eingang des Transistors F3 liegt die Spannung U2_inv an, wobei die Spannung U2_inv die zu U2 inverse Spannung ist. Das bedeutet, ist die Spannung U2 positiv, dann ist die Spannung U2 = 0V und umgekehrt.

Im Zustand minimaler Dämpfung ist der Transistor F2 leitend. d.h. am Eingang des Transistors F2 liegt eine positive Spannung an. Da die Spannung am Eingang des Transistors F3 gerade invers zu der am Transistor F2 anliegenden Spannung ist, ist der Transistor F3 gesperrt.

Die Dämpfung erfolgt bei umgekehrten Spannungsverhältnissen, d.h. F3 ist leitend (anliegende Spannung U2_inv ist positiv) und F2 sperrt (anliegende Spannung ist 0V). Somit wird das Sollsignal E durch die Widerstände R3, R4, R5 und R6 gedämpft. Die Induktivitäten L1 und L2 dienen zur Phasenkompensation.

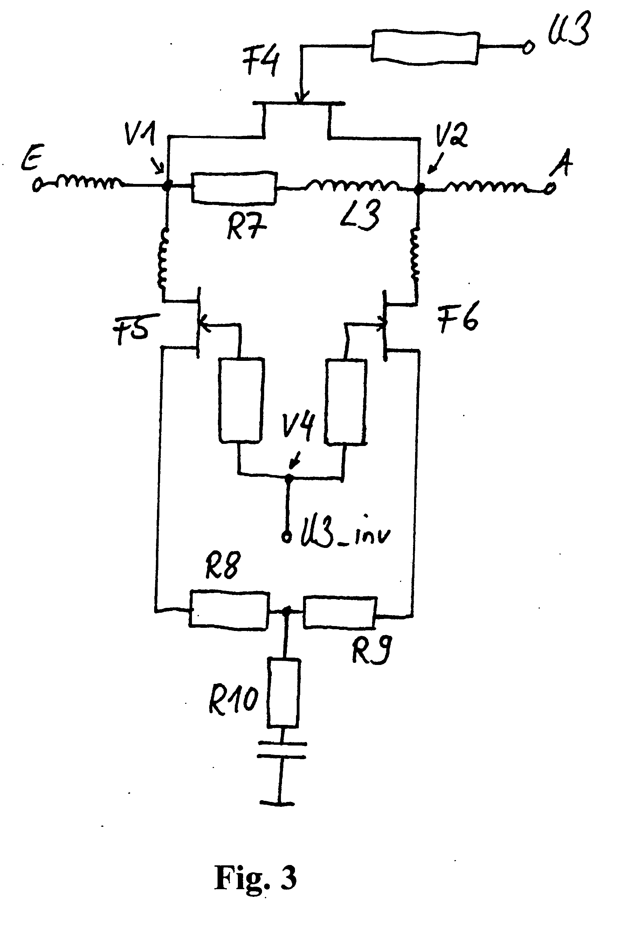

Fig. 3 zeigt eine Ausführungsform einer erfindungsgemäßen HF-Schaltung für ein Dämpfungsglied mit einem Dämpfungswert von 8 dB. Das Sollsignal E wird der HF-Schaltung über eine Induktivität dem Verbindungspunkt V1 des Widerstands R7, einem Ausgang des Transistors F4 sowie der Induktivität L1 zugeführt. Der Widerstand R7 ist weiterhin mit der Induktivität L3 verbunden. Der andere Ausgang des Transistors F4 ist mit dem Verbindungspunkt V2 der Induktivität L2 und der Induktivität L3 verbunden. Von dem Verbindungspunkt V2 wird das Istsignal E über eine weitere Induktivität zur Verbesserung der Anpassung der HF-Schaltung entnommen.

Die Induktivitäten L1 ist mit einem Eingang des Transistors F5 verbunden. Der andere Ausgang des Transistors F5 ist mit dem Widerstand R8 verbunden. Die Induktivitäten L2 ist mit einem Eingang des Transistors F6 verbunden. Der andere Ausgang des Transistors F6 ist mit dem Widerstand R9 verbunden, welcher wiederum mit dem Widerstand R8 im Verbindungspunkt V3 verbunden ist. Dieser Verbindungspunkt V3 ist über den Widerstand R10 und eine Kapazität mit Masse verbunden.

An den Eingängen der Transistoren F5 und F6 liegt jeweils über einen Widerstand die Spannung U3_inv an. Die Spannung U3 liegt am Eingang des Transistors F4 an.

Der Zustand minimaler Dämpfung wird erreicht, wenn der Transistor F4 leitend ist, d.h. wenn die Spannung U3 positiv ist. Gleichzeitig sperren die Transistoren F5 und F6, da hier die Spannung U3_inv = 0V anliegt. Liegt am Eingang des Transistors F4 die Spannung U3 = 0V an, dann sperrt der Transistor F4 und durch die Widerstände R7, R8, R9 und R10 wird eine Dämpfung erreicht. Gleichzeitig liegt aufgrund der inversen Spannung an den Transistoren F5 und F6 eine positive Spannung an. Die Spulen L1, L2 und L3 dienen der Phasenkompensation.

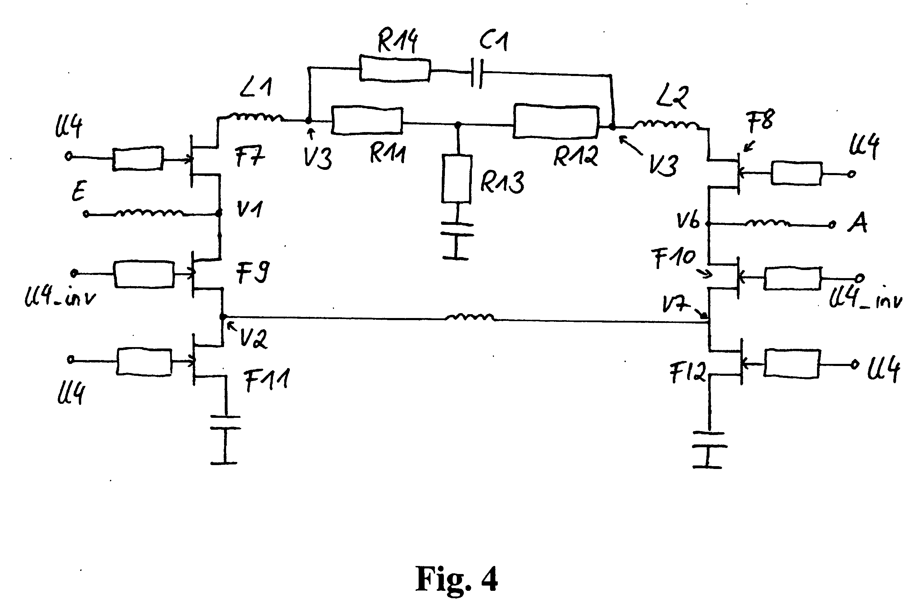

Fig. 4 zeigt eine Ausführungsform einer erfindungsgemäßen HF-Schaltung für ein Dämpfungsglied mit einem Dämpfungswert von 16 dB. Ein Ausgang des Transistors F7 und ein Ausgang des Transistors F8 ist im Verbindungspunkt V1 miteinander verbunden. Der HF-Schaltung wird über eine Induktivität zur verbesserten Anpassung das Sollsignal E dem Verbindungspunkt V1 zugeführt. Der andere Ausgang des Transistors F9 ist im Verbindungspunkt V2 mit einem Ausgang des Transistors F11 verbunden, dessen anderer Ausgang über eine Kapazität an Masse geschlossen ist.

Der andere Ausgang des Transistors F7 ist über eine Induktivität L1 mit dem Verbindungspunkt V3 des Widerstands R11 mit dem Widerstand R14 verbunden. Der Widerstand R14 ist im Verbindungspunkt V4 über eine Kapazität C1 mit dem Widerstand R12 verbunden. Die Widerstände R12 und R11 sind im Verbindungspunkt V5 miteinander verbunden. Der Verbindungspunkt V5 ist über den Widerstand R13 und eine Kapazität an Masse geschlossen.

An den Verbindungspunkt V4 ist über eine Induktivität L2 ein Ausgang des Transistors F8 angeschlossen. Der andere Ausgang des Transistors F8 ist über den Verbindungspunkt V6 mit einem Ausgang des Transistors F10 verbunden. Dem Verbindungspunkt V6 wird über eine Induktivität zur Verbesserung der Anpassung das Istsignal A entnommen. Der andere Ausgang des Transistors F10 ist über den Verbindungspunkt V7 mit einem Ausgang des Transistors F12 verbunden, dessen anderer Ausgang über eine Kapazität an Masse geschlossen ist.

Die beiden Verbindungspunkte V2 und V7 sind über eine Induktivität miteinander verbunden.

An den Eingängen der Transistoren F7, F8, F11 und F12 liegt jeweils über einen Widerstand die Spannung U4 an. Die Spannung U4_inv liegt jeweils über einen Widerstand an den Eingänge der Transistoren F9 und F10 an.

Ist die Spannung U4_inv positiv, dann sind die Transistoren F9 und F10 leitend und es liegt minimale Dämpfung vor. Gleichzeitig sperren die Transistoren F7, F8, F11, F12, da hier die Spannung U4 = 0V anliegt.

Die HF-Schaltung ist im dämpfenden Zustand geschaltet, wenn die Spannung U4_inv = 0V beträgt. In diesem Fall sperren die Transistoren F9 und F10 und es erfolgt eine Dämpfung über die Widerstände R11, R12, R13 und R14. Gleichzeitig liegt an den Transistoren F7, F8, F11, F12 eine positive Spannung an, weshalb diese Transistoren leitend sind. Die Induktivitäten L1 und L2 sowie die Kapazität C1 dienen der Phasenkompensation.

Selbstverständlich können die Eingänge für das Sollsignal E und die Ausgänge für das Istsignal A in den beschriebenen HF-Schaltungen vertauscht werden.

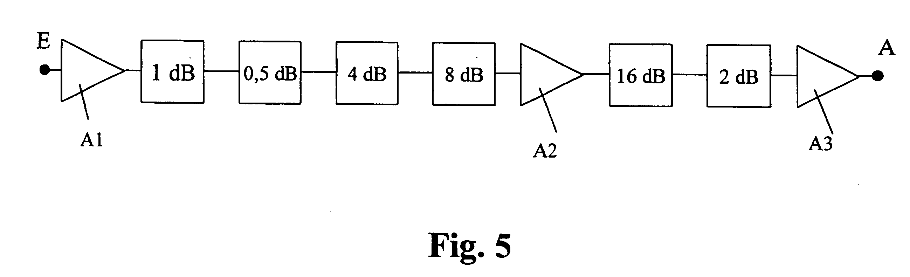

Fig. 5 zeigt eine beispielhafte Kombination von den erfindungsgemäßen Dämpfungsgliedern mit verschiedenen Dämpfungswerten. Dabei wird das Sollsignal E einem Verstärker A1 zugeführt. Das Signal wird dann einem Dämpfungsglied D1 mit einem Dämpfungswert von 1 dB zugeführt, anschließend gelangt das Signal in ein Dämpfungsglied D2 mit einem Dämpfungswert von 0,5 dB. Von dort wird das Signal einem Dämpfungsglied mit 4 dB, dem ein Dämpfungsglied mit 8 dB nachgeschaltet ist, zugeführt. Letzeren ist ein weiterer Verstärker A2 nachgeschaltet. Dem Verstärker A2 folgt ein Dämpfungsglied mit 16 dB, dem ein Dämpfungsglied mit 2 dB in Reihe geschaltet ist. Letzeren Dämpfungsglied ist ein dritter Verstärker A3 nachgeschaltet, an dessen Ausgang das Istsignal A entnommen wird.

## Patentansprüche

1. Integrierte HF-Schaltung mit Dämpfungsgliedern aufweisend einen Eingang (E), einen Ausgang (A) und Feldeffekttransisitoren (F1, F2, F3, F4, F5, F6, F7, F8, F9, F10) als Schaltelemente mit positiven Versorgungsspannungen (U1, U2, U2_inv, U3, U3_inv, U4, U4_inv), wobei die Dämpfungsglieder die Amplitude eines an den Eingang (E) angelegten Sollsignals gemäß einem zwischen zwei Zuständen schaltbaren Dämpfungszustand steuert und am Ausgang (A) ein Istsignal erzeugt, **dadurch gekennzeichnet, dass** die Dämpfungsglieder Induktivitäten (L1, L2, L3) und/oder Kapazitäten (C1) zur Phasenkompensation aufweisen und dass die Feldeffekttransistoren (F1, F2, F3, F4, F5, F6, F7, F8, F9, F10) leistungslos ansteuerbar sind.

2. Integrierte HF-Schaltung nach Anspruch 1, **dadurch gekennzeichnet, dass** die Induktivitäten (L1, L2, L3) und/oder Kapazitäten (C1) derart miteinander verschaltet sind, dass eine Phasenänderung des Sollsignals in einem Dämpfungsglied kompensierbar ist.

3. Integrierte HF-Schaltung nach einem der vorangehenden Ansprüche, **dadurch gekennzeichnet, dass** die Dämpfungsglieder in Reihe geschaltet sind.

4. Integrierte HF-Schaltung nach Anspruch 3, **dadurch gekennzeichnet, dass** die in Reihe geschalteten Dämpfungsglieder jeweils in einen Zustand mit wenig Verlust und definiertem Verlust schaltbar sind.

5. Integrierte HF-Schaltung nach einem der vorangehenden Ansprüche, **dadurch gekennzeichnet, dass** die Dämpfungsglieder eine Dämpfung von 0,5 dB, 1 dB, 2 dB, 4 dB, 8 dB, 16 dB aufweist.

6. Integrierte HF-Schaltung nach einem der vorangehenden Ansprüche, **dadurch gekennzeichnet, dass** zusätzliche Verstärkerstufen (A2) vorhanden sind, die zwischen den Dämpfungsgliedern verschaltet sind.

7. Integrierte HF-Schaltung nach einem der vorangehenden Ansprüche, **dadurch gekennzeichnet, dass** die Schaltelemente mittels positiver Digitalpegel, insbesondere TTL- oder CMOS-Pegel ansteuerbar ist.

## Claims

1. Integrated RF circuit with attenuating elements having an input (E), an output (A) and field-effect transistors (F1, F2, F3, F4, F5, F6, F7, F8, F9, F10) as switching elements with positive supply voltages (U1, U2, U2_inv, U3, U3_inv, U4, U4_inv), wherein the attenuating elements control the amplitude of a set signal, which is applied to the input (E), according to an attenuation state which is switchable between two states, and produce an actual signal at the output (A), **characterized in that** the attenuating elements have inductances (L1, L2, L3) and/or capacitances (C1) for phase compensation, and **in that** the field-effect transistors (F1, F2, F3, F4, F5, F6, F7, F8, F9, F10) can be driven without any power loss.

2. Integrated RF circuit according to Claim 1, **characterized in that** the inductances (L1, L2, L3) and/or capacitances (C1) are connected to one another such that any phase change of the set signal in an attenuating element can be compensated for.

3. Integrated RF circuit according to one of the preceding claims, **characterized in that** the attenuating elements are connected in series.

4. Integrated RF circuit according to Claim 3, **characterized in that** the series-connected attenuating elements can each be switched to a state with low loss and defined loss.

5. Integrated RF circuit according to one of the preceding claims, **characterized in that** the attenuating elements have an attenuation of 0.5 dB, 1 dB, 2 dB, 4 dB, 8 dB and 16 dB.

6. Integrated RF circuit according to one of the preceding claims, **characterized in that** additional amplifier stages (A2) are provided, and are connected between the attenuating elements.

7. Integrated RF circuit according to one of the preceding claims, **characterized in that** the switching elements can be operated by means of a positive digital level, in particular by means of a TTL or CMOS level.

## Revendications

1. Circuit intégré HF avec des éléments d'amortissement comportant une entrée (E), une sortie (A) et des transistors à effet de champ (F1, F2, F3, F4, F5, F6, F7, F8, F9, F10) comme éléments de commutation avec des tensions d'alimentation positives (U1, U2, U2_inv, U3, U3_inv, U4, U4_inv), dans lequel les éléments d'amortissement pilotent l'amplitude d'un signal de consigne appliqué à l'entrée (E) selon un état d'amortissement commutable entre deux états et génèrent un signal de valeur réelle à la sortie (A), **caractérisé en ce que** les éléments d'amortissement comportent des inductances (L1, L2, L3) et/ou des condensateurs (C1) pour la compensation de phases et **en ce que** les transistors à effet de champ (F1, F2, F3, F4, F5, F6, F7, F8, F9, F10) peuvent être commandés sans dissipation de puissance.

2. Circuit intégré HF selon la revendication 1, **caractérisé en ce que** les inductances (L1, L2, L3) et/ou les condensateurs (C1) sont branchés entre eux de telle sorte qu'une modification de la phase du signal de consigne puisse être compensée dans un élément d'amortissement.

3. Circuit intégré HF selon l'une des revendications précédentes, **caractérisé en ce que** les éléments d'amortissement sont branchés en série.

4. Circuit intégré HF selon la revendication 3, **caractérisé en ce que** les éléments d'amortissement branchés en série sont respectivement commutables dans un état avec peu de pertes et avec une perte définie.

5. Circuit intégré HF selon l'une des revendications précédentes, **caractérisé en ce que** les éléments d'amortissement comportent un amortissement de 0,5 dB, 1 dB, 2 dB, 4 dB, 8 dB, 16 dB.

6. Circuit intégré HF selon l'une des revendications précédentes, **caractérisé en ce qu'**il y a des étages d'amplification supplémentaires (A2) qui sont branchés entre les éléments d'amortissement.

7. Circuit intégré HF selon une des revendications précédentes, **caractérisé en ce que** les éléments de commutations peuvent être commandés au moyen de niveaux numériques, notamment des niveaux TTL ou CMOS.
